# EUROPÄISCHE PATENTSCHRIFT

(11) **EP 3 777 049 B1**
(45) Veröffentlichungstag und Bekanntmachung des Hinweises auf die Patenterteilung: **04.09.2024**
(21) Anmeldenummer: 19712988.5
(22) Anmeldetag: 21.03.2019
(51) Int. Cl.: H04L 12/40, H04L 25/12

(54) **SCHALTUNG FÜR EIN BUSSYSTEM UND VERFAHREN ZUM BETREIBEN EINER SCHALTUNG**
CIRCUIT FOR A BUS SYSTEM AND METHOD FOR OPERATING A CIRCUIT
CIRCUIT POUR SYSTÈME DE BUS ET PROCÉDÉ DE FONCTIONNEMENT D'UN CIRCUIT

(30) Priorität: 06.04.2018 DE 102018205217
(43) Veröffentlichungstag der Anmeldung: 17.02.2021
(73) Patentinhaber: Robert Bosch GmbH, 70442 Stuttgart (DE)
(72) Erfinder: WALKER, Steffen, 72770 Reutlingen (DE); MUTTER, Arthur, 73765 Neuhausen (DE)
(86) Internationale Anmeldenummer: PCT/EP2019/057114
(87) Internationale Veröffentlichungsnummer: WO 2019/192851

(56) Entgegenhaltungen:
- EP-A2- 1 202 451
- WO-A1-2015/185057
- DE-A1- 102015 222 334
- JP-A- H06 152 610
- US-A1- 2010 177 829

## Beschreibung

### Stand der Technik

Die Erfindung betrifft eine Schaltung für ein Bussystem sowie ein Verfahren zum Betreiben einer Schaltung für ein Bussystem.

Es ist bekannt, dass lang andauernde Schwingungen einer Busspannung eines Bussystems durch nicht fachgerechte Terminierung oder eine nicht fachgerechte Topologie des Bussystems wesentliche Faktoren sind, welche zu einer fehlerträchtigen Datenübertragung führen können. Insbesondere eine Verkürzung der Bitzeit aufgrund erhöhter Übertragungsraten ist hierbei problematisch.

Um Schwingungen der Spannung zu kompensieren ist aus der DE 10 2015 222 334 A1 bekannt, dass Busschwingungen beim Datenempfang selektiv ausgeblendet werden. Es ist ein Maskierungselement zur Maskierung von Schwingungen des Bussignals für eine vorbestimmte Maskierungszeit vorgesehen, wenn ein Überwachungsergebnis ergibt, dass Schwingungen eine Differenz des Bussignals nach einem Übergang des Bussignals von einem dominanten zu einem rezessiven Zustand mindestens einen vorbestimmten Schwellwert überschreiten.

Aus der JP H06 152610 A ist ein Bussystem bekannt, bei dem ein Abschlusswiderstand in Abhängigkeit von einer gemessenen Impedanz eingestellt wird. Die EP 1 202 451 A2 offenbart einen On-Chip-Abschluss von Übertragungsleitungen, die den Abschluss von Übertragungsleitungen unter Verwendung von On-Chip-Widerständen ermöglichen, die zu Netzwerken konfiguriert sind, deren Widerstände auf den Widerstand eines externen Referenzwiderstands bezogen sind. Die WO 2015/185057 A1 offenbart ein Bussystem mit mindestens drei Steuergeräte zu Kommunikationszwecken, wobei jedem Steuergerät ein Busabschlusswiderstand mit einem vorgegebenen Widerstandswert zur Anpassung eines Steuergerätewiderstandes an einen Bussystemwiderstand zugeordnet ist. Die US 2010/177829 A1 offenbart einen Receiver mit einer Impedanzsteuerungsschaltung. Die Impedanzsteuerungsschaltung ändert eine Eingangsimpedanz basierend auf einem erfassten Wert.

### Offenbarung der Erfindung

Die Probleme des Standes der Technik werden durch eine Schaltung nach dem Anspruch 1 und ein Verfahren nach einem nebengeordneten Anspruch gelöst. Vorteilhafte Weiterbildungen sind in den Unteransprüchen sowie in der nachfolgenden Beschreibung von Ausführungsbeispielen angegeben. Gemäß einem ersten Aspekt dieser Beschreibung wird eine Schaltung für ein Bussystem bereitgestellt. Die Schaltung umfasst: Eine Messschaltung, welche konfiguriert ist, um einen ersten Widerstandswert zwischen zwei bus-seitigen Anschlüssen der Schaltung zu messen; eine Ermittlungsschaltung, welche konfiguriert ist, um einen zweiten Widerstandswert in Abhängigkeit von dem ersten Widerstandswert zu ermitteln; und eine Widerstandsschaltung, welche konfiguriert ist, um einen zwischen die zwei bus-seitigen Anschlüsse schaltbaren Widerstand auf den zweiten Widerstandswert einzustellen. Vorteilhaft wird durch die Einstellung des Widerstands auf den zweiten Widerstandswert erreicht, dass der erste Widerstandswert, der an den bus-seitigen Anschlüssen gemessen wurde, sich - die Aktivierung des Widerstands der Widerstandsschaltung mit dem zweiten Widerstandswert vorausgesetzt - in einem Bereich befindet, bei dem die Kommunikation über das Bussystem aufrechterhalten wird. Insbesondere wird durch die Anpassung des Widerstandswerts des Widerstands erreicht, dass ein Mindestwert für den ersten Widerstandswert von beispielsweise 50 Ohm nicht unterschritten wird.

Eine vorteilhafte Ausführungsform zeichnet sich dadurch aus, dass die Ermittlungsschaltung konfiguriert ist, um den zweiten Widerstandswerts zu erhöhen, wenn der erste Widerstandswert sinkt. Vorteilhaft wird durch diese Erhöhung des zweiten Widerstandswerts der erste Widerstandswert stabilisiert, was die Robustheit der Kommunikation über das Bussystem verbessert.

DieMessschaltung ist konfiguriert, um zumindest ein Zeitfenster in Abhängigkeit von einer über die beiden bus-seitigen Anschlüsse empfangenen Nachricht und in Abhängigkeit von einer a-priori bekannten Position in Bezug zu der empfangenen Nachricht zu ermitteln, wobei die Widerstandsschaltung konfiguriert ist, um den zwischen den zwei bus-seitigen Anschlüssen geschalteten Widerstand während des ermittelten Zeitfensters auf den zuletzt ermittelten zweiten Widerstandswert einzustellen, und wobei die Messschaltung konfiguriert ist, um eine Wartezeitdauer nach einem Beginn des Zeitfensters abzuwarten, und um anschließend an die Wartezeitdauer und noch vor Ende des Zeitfensters den ersten Widerstandswert zwischen den beiden bus-seitigen Anschlüssen während einer Messzeitdauer zu messen. Vorteilhaft werden durch die a-priori bekannte Position in der Nachricht negative Auswirkungen auf die Kommunikation verhindert.

Eine vorteilhafte Ausführungsform zeichnet sich dadurch aus, dass die Länge der Wartezeitdauer und/oder der Messzeitdauer eine Bit-Zeit oder kürzer ist. Bei einem korrekt konfigurierten Bussystem kann davon ausgegangen werden, dass die Signallaufzeit kürzer ist als die Bitzeit. Vorteilhaft werden durch die Mindestvorgabe der Bit-Zeit für die Messzeitdauer und die Wartezeitdauer negative Effekte auf die Messung des ersten Widerstands aufgrund hoher Signallaufzeiten im Bussystem reduziert.

Eine vorteilhafte Ausführungsform zeichnet sich dadurch aus, dass die Widerstandsschaltung konfiguriert ist, um das Zeitfenster zur Zuschaltung des Widerstandes zu ermitteln, und um den Widerstand während des Zeitfensters mit dem zuletzt ermittelten zweiten Widerstandswert zuzuschalten, und wobei die Messschaltung konfiguriert ist, um den ersten Widerstand während des Zeitfensters zu ermitteln. Vorteilhaft wird während der tatsächlichen Schwingungsdämpfung gemessen, womit der zweite Widerstandswert in Abhängigkeit vom tatsächlichen Betrieb bzw. vom tatsächlichen Zuschalten zur Schwingungsdämpfung ermittelt wird. Damit kann der zweite Widerstandswert genauer an die gewünschte Dämpfungswirkung angepasst werden.

Eine vorteilhafte Ausführungsform zeichnet sich dadurch aus, dass die Ermittlungsschaltung konfiguriert ist, um den zweiten Widerstandswert in Abhängigkeit von einem Vergleich des ersten Widerstandswerts mit einem Soll-Wert für den ersten Widerstandswert zu ermitteln. Vorteilhaft wird eine Regelschleife geschaffen, welche sicherstellt, dass das Bussystem selbstständig einen Wert für den Gesamtwiderstand findet, um Ringing Suppression durchzuführen.

Eine vorteilhafte Ausführungsform zeichnet sich dadurch aus, dass die Ermittlungsschaltung konfiguriert ist, um den zweiten Widerstandswerts mittels einer Lookup-Tabelle in Abhängigkeit von dem ersten Widerstandswert zu ermitteln. Durch die Lookup-Tabelle wird das Auffinden des passenden zweiten Widerstandswerts auf einfache Art und Weise gelöst.

Eine vorteilhafte Ausführungsform zeichnet sich dadurch aus, dass die Schaltung umfasst: Eine Konfigurationsschaltung, welche konfiguriert ist, um eine Anzahl von Teilnehmerstationen des Bussystems bereitzustellen; und die Ermittlungsschaltung, welche konfiguriert ist, um den zweiten Widerstandswerts mittels der Lookup-Tabelle in Abhängigkeit von dem ersten Widerstandswert und in Abhängigkeit von der bereitgestellten Anzahl von Teilnehmerstationen zu ermitteln. Durch die Berücksichtigung der Anzahl der Teilnehmerstationen erfolgt eine Anpassung des zweiten Widerstandswerts an die tatsächliche Buskonfiguration. Insbesondere wird hierdurch kritischen Betriebszuständen vorgebeugt, welche ein starkes Absinken des ersten Widerstandswerts insbesondere unter die Grenze von 50 Ohm vorbeugt.

Ein weiterer Aspekt der Beschreibung betrifft einen Transceiver für eine Teilnehmerstation eines Bussystems, wobei der Transceiver die Schaltung nach dem ersten Aspekt umfasst.

Ein weiterer Aspekt der Beschreibung betrifft ein Verfahren zum Betreiben einer Schaltung für ein Bussystem, wobei das Verfahren umfasst: Messen eines ersten Widerstandswerts zwischen zwei bus-seitigen Anschlüssen der Schaltung; Ermitteln eines zweiten Widerstandswerts in Abhängigkeit von dem ersten Widerstandswert; und Einstellen eines zwischen die zwei bus-seitigen Anschlüsse schaltbaren Widerstands auf den zweiten Widerstandswert, wobei zumindest ein Zeitfenster in Abhängigkeit von einer über die beiden bus-seitigen Anschlüsse empfangenen Nachricht und in Abhängigkeit von einer a-priori bekannten Position in Bezug zu der empfangenen Nachricht zu ermittel wird, wobei der zwischen den zwei bus-seitigen Anschlüssen geschaltete Widerstand während des ermittelten Zeitfensters auf den zuletzt ermittelten zweiten Widerstandswert eingestellt wird, und wobei eine Wartezeitdauer nach einem Beginn des Zeitfensters abgewartet wird, um anschließend an die Wartezeitdauer und noch vor Ende des Zeitfensters den ersten Widerstandswert zwischen den beiden bus-seitigen Anschlüssen während einer Messzeitdauer zu messen.

In den Figuren zeigen:
- Figuren 1, 2a, 2b: Jeweils eine Schaltung in schematischer Form;
- Figur 3: ein schematisches Protokolldiagramm;
- Figur 4a, 4b: jeweils ein schematisches Blockdiagramm; und
- Figur 5: ein beispielhaftes Bussystem in schematischer Form.

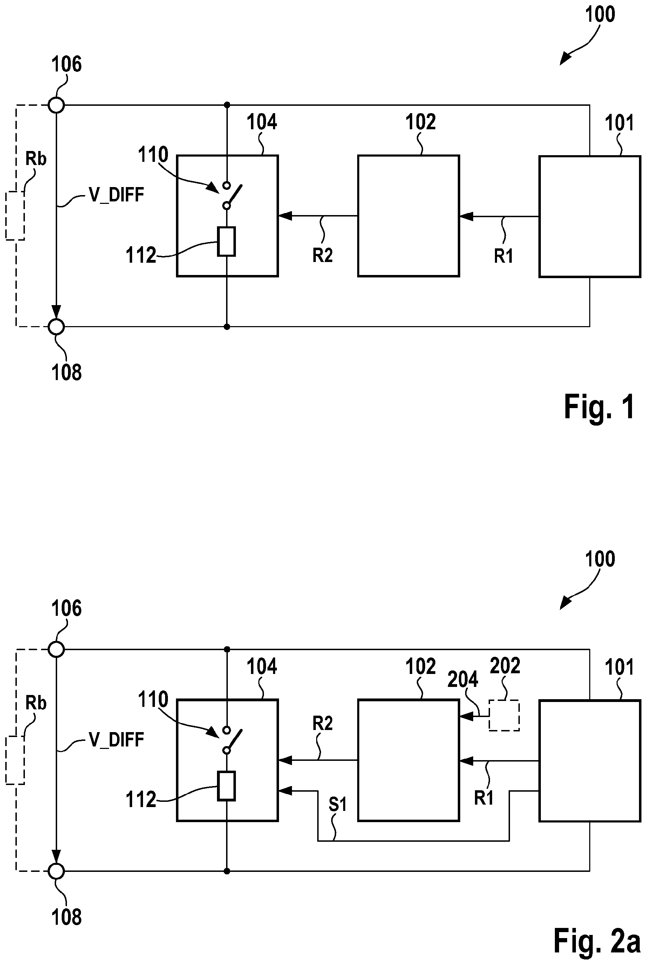

Figur 1 zeigt eine Schaltung 100 für ein Bussystem. Die Schaltung 100 umfasst eine Messschaltung 101, eine Ermittlungsschaltung 102 und eine Widerstandsschaltung 104, wobei die Messschaltung 101 und die Widerstandsschaltung 104 parallel zueinander zwischen zwei bus-seitigen Anschlüssen 106 und 108 der Schaltung 100 angeordnet sind. Über den Anschluss 106 wird die Schaltung 100 an eine erste Busleitung CAN_H angeschlossen. Über den Anschluss 108 wird die Schaltung 100 an eine zweite Busleitung CAN_L angeschlossen. Eine Spannung V_DIFF fällt zwischen den beiden Anschlüssen 106 und 108 ab.

Die Messschaltung 101, die Ermittlungsschaltung 102 und die Widerstandsschaltung 104 sind beispielsweise als ASIC, FPGA oder als diskrete Schaltung ausgebildet. Des Weiteren umfassen Messschaltung 101, die Ermittlungsschaltung 102 und die Widerstandsschaltung 104 beispielsweise einen Prozessor, der mit Software ausgestattet ist, um die jeweiligen durch Software definierten Funktionen auszuführen. Selbstverständlich sind auch Mischformen umfassend eine physische Schaltung und den Prozessor, auf welchem die Software ausgeführt wird, denkbar. Die Software ist auf einem entsprechenden Speicherelement abgelegt. Die Schaltung 100 ist beispielsweise Teil eines Transceivers für eine Teilnehmerstation eines Bussystems. In einer anderen Ausführungsform ist die Schaltung 100 zusätzlich zu einem vorhandenen Transceiver ausgeführt.

In schematischer Form dargestellt umfasst die Widerstandsschaltung 104 einen Schalter 110 und einen in Serie hierzu angeordneten Widerstand 112. Selbstverständlich kann die Widerstandsschaltung 104 auch anders ausgeführt sein und beispielsweise einen MOS-FET umfassen. Der Widerstand 112 wird beispielsweise dann zwischen die beiden bus-seitigen Anschlüsse 106, 108 geschaltet, wenn ein Zustandsübergang von einem ersten Zustand (beispielsweise dominant) eines Absolutwerts der Spannung V_DIFF zu einem zweiten Zustand (beispielsweise rezessiv) beispielsweise innerhalb eines ermittelten Zeitfensters auftritt. Die Widerstandsschaltung 104 dient zur Unterdrückung bzw. Dämpfung von Schwingungen der Spannung V_DIFF.

Die Messschaltung 101 ermittelt einen ersten Widerstandswert R1 zwischen den beiden bus-seitigen Anschlüssen 106 und 108. die Ermittlung des ersten Widerstandswerts R1 erfolgt beispielsweise in regelmäßigen Abständen. So kann die Ermittlung beispielsweise in jedem Datenrahmen oder nur einmal pro Minute durchgeführt werden. Dieser erste Widerstandswert R1 reflektiert den zwischen den beiden Anschlüssen 106 und 108 geschalteten Gesamtwiderstand, der sich beispielsweise durch die Parallelschaltung eines Bus-Widerstandes Rb und den Widerstand 112 ergibt. Die Ermittlungsschaltung 102 ermittelt in Abhängigkeit von dem zugeführten ersten Widerstandswert R1 einen zweiten Widerstandswert R2 für den Widerstand 112 der Widerstandsschaltung 104. Beim Start der Schaltung wird ein vordefinierter Wert für den zweiten Widerstandswert R2 verwendet. Der zweite Widerstandswert R2 wird der Widerstandsschaltung 104 zugeführt, um den Widerstand 112 auf den zweiten Widerstandswert R2 einzustellen. Die Widerstandsschaltung 104 schaltet entweder auf Anforderung von außen oder selbstständig den Widerstand 112 zwischen die beiden Anschlüsse 106 und 108, wobei der Widerstand 112 auf den zuletzt ermittelten Widerstandswert R2 eingestellt wird.

Figur 2a zeigt die Schaltung 100, wobei die Messschaltung 101 die Widerstandsschaltung 104 mittels eines Signales S1 aktiviert, damit bei der anschließend durchgeführten Messung der zwischen den beiden Anschlüssen 106, 108 geschaltete Widerstand mit gemessen wird. Die Messschaltung 101 ermittelt zumindest ein Zeitfenster in Abhängigkeit von einer Nachricht, welche über den Bus empfangen wird oder welche auf dem Bus gesendet wird, und in Abhängigkeit von einer vorbekannten Position in Bezug zu der Nachricht. Hierzu wird Wissen über das Protokoll verwendet, insbesondere wird in Abhängigkeit von der Spannung V_DIFF das Vorliegen einer Nachricht und deren zeitliche Position ermittelt. Die Widerstandsschaltung 100 wird dann mithilfe des Signals S1 derart betrieben, dass während der ermittelten Zeitdauer der zweite Widerstandswert R2 für den zwischen die Anschlüsse 106, 108 geschalteten Widerstand eingestellt ist. Nach dem Zwischenschalten des Widerstandes wird eine Wartezeitdauer abgewartet und anschließend der erste Widerstandswert mittels der Messschaltung 101 während einer Messzeitdauer gemessen. Während der Messzeitdauer wird ein Verlauf des ersten Widerstandswerts ermittelt und als erster Widerstandswert das Minimum des Verlaufs ausgegeben. Sowohl die Wartezeitdauer als auch die Messzeit sind beispielsweise eine nominale Bitzeit lang, weil die nominale Bitzeit ca. 70 % aus einer Roundtripzeit besteht, die zwingend abgewartet werden muss. In einem anderen Beispiel sind die Wartezeitdauer als auch die Messzeit kürzer als die nominale Bitzeit.

Eine Konfigurationsschaltung 202 stellt eine Anzahl 204 von Teilnehmerstationen des Bussystems bereit. Die Anzahl 204 kann entweder vorkonfiguriert sein oder die Konfigurationsschaltung ermittelt selbstständig die Anzahl 204 von Teilnehmerstationen. Zu der selbstständigen Ermittlung der Anzahl 204 tauscht die Konfigurationsschaltung 202 Nachrichten mit anderen Busteilnehmern aus. Die Ermittlungsschaltung 102 kann beispielsweise für eine erhöhte Anzahl 204 den zweiten Widerstandswert R2 kleiner bestimmen als bei Vorliegen einer verringerten Anzahl 204.

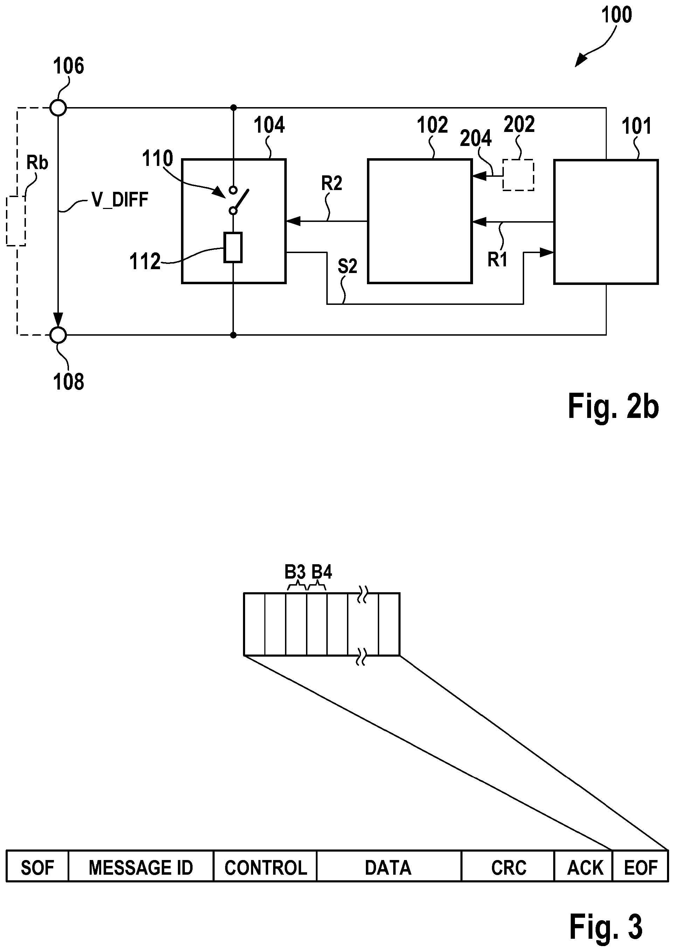

Figur 2b zeigt die Schaltung 100. Im Unterschied zur Figur 2a wird ein Signal S2 von der Widerstandsschaltung 104 an die Messschaltung 101 übermittelt. Die Widerstandsschaltung 104 ermittelt selbstständig das Zeitfenster zur Zuschaltung des Widerstandes. Die Ermittlung des Zeitfensters kann als Grundfunktion zum Betrieb der Widerstandsschaltung angesehen werden. Über das Signal S2 wird der Messschaltung 101 signalisiert, dass der Widerstand zugeschaltet ist; es wird also das Zeitfenster an die Messschaltung 101 übergeben. Solange das Signal S2 die Zuschaltung des Widerstands signalisiert, führt die Messschaltung eine Messung des ersten Widerstandes durch.

Figur 3 zeigt einen Aufbau einer CAN-Nachricht und die zeitliche Anordnung der Messung des ersten Widerstandswerts. Die gezeigte Nachricht umfasst folgende Felder: Start of frame (SOF), Message Identifier (MID), Remote Transmission Request (RTR), Control field (CONTROL), Data Field (DATA), CRC field (CRC), Acknowledge field (ACK), End of Frame (EOF). Beispielsweise wird zu Beginn des dritten Bits B3 der Widerstand der Widerstandsschaltung 104 zugeschaltet, um im darauffolgenden vierten Bit B4 die Messung des ersten Widerstandswerts durchzuführen. Alternativ oder zusätzlich erfolgt die Zuschaltung des Widerstands der Widerstandsschaltung und die Messung des ersten Widerstandswert innerhalb des Intermission Field, welches sich zwischen dem End Of Frame EOF und dem Start Of Frame SOF befindet. Das dritte und vierte Bit B3, B4 sowie das Intermission Field eignen sich aufgrund des rezessiven Buspegels besonders gut zur Zuschaltung des Widerstands der Widerstandsschaltung 104.

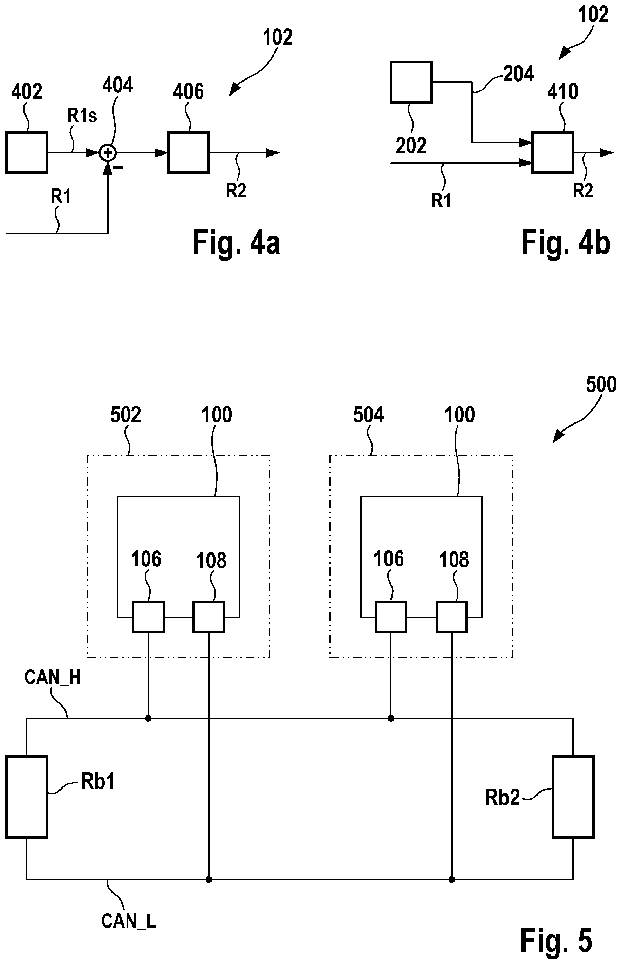

Figur 4a zeigt die Ermittlungsschaltung 102 in einem schematischen Ausschnitt. Ein Block 402 erzeugt einen Sollwert R1s und führt diesen einer Additionsstelle 404 zu. Der gemessene erste Widerstandswert R1 wird an der Additionsstelle 404 von dem Sollwert R1s subtrahiert, um eine Regeldifferenz d zu ermitteln. Ein Regler 406 ermittelt in Abhängigkeit von der Regeldifferenz d den zweiten Widerstandswert R2, welcher vorliegend als Stellgröße fungiert. Der Regler 406 kann beispielsweise ein PID-Regler oder ein andersartig ausgeführter Regler sein.

Figur 4b zeigt die Ermittlungsschaltung 102 in einem schematischen Ausschnitt. Die Konfigurationsschaltung 202 stellt einem Block 410 die Anzahl 204 von Busteilnehmern bereit. Der Block 410 umfasst eine Lookup-Tabelle, welche in Abhängigkeit von der Anzahl 204 und in Abhängigkeit von dem ersten Widerstandswert R1 den zweiten Widerstandswert R2 ermittelt. Die Lookup-Tabelle ist in einem Speicherelement abgelegt. Eine noch einfacherer Variante ist auch denkbar, in der der Widerstand R2 mithilfe des Blocks 410, welcher eine Lookup-Tabelle enthält, in Abhängigkeit von dem Widerstand R1 ermittelt wird.

Figur 5 zeigt ein beispielhaft konfiguriertes Bussystem umfassend zwei Teilnehmerstationen 502, 504. Jede der Teilnehmerstation 502, 504 umfasst die jeweilige Schaltung 100, welche mit dem ersten Anschluss 106 an die erste Busleitung CAN_H und mit dem zweiten Anschluss 108 an die zweite Busleitung CAN_L angeschlossen ist. Die Busleitungen CAN_H und CAN_L sind an ihren Enden über einen jeweiligen Abschlusswiderstand Rb1 und Rb2 miteinander verbunden. Durch das Zu- und Wegschalten des Widerstands zwischen den bus-seitigen Anschlüssen 106, 108 bewirken die jeweiligen Schaltungen 100 der Teilnehmerstation 502 und 504, dass Schwingungen bei einem Zustandswechsel von dominant zu rezessiv gedämpft und damit reduziert werden. Das Bussystem 500 arbeitet gemäß den Ausführungsbeispielen nach dem CAN-Standard wie beispielsweise ISO11898. Die Schaltung 100 und der Betrieb der Schaltung kann jedoch ohne Weiteres auch auf andere Bussysteme übertragen werden. Darüber hinaus sind auch andere Bustopologien denkbar.

## Patentansprüche

1. Eine Schaltung (100) für ein Bussystem, wobei die Schaltung (100) umfasst:
- eine Messschaltung (101), welche konfiguriert ist, um einen ersten Widerstandswert zwischen zwei bus-seitigen Anschlüssen (106, 108) der Schaltung (100) zu messen;
- eine Ermittlungsschaltung (102), welche konfiguriert ist, um einen zweiten Widerstandswert in Abhängigkeit von dem ersten Widerstandswert zu ermitteln; und
- eine Widerstandsschaltung (104), welche konfiguriert ist, um einen zwischen die zwei bus-seitigen Anschlüsse (106, 108) schaltbaren Widerstand auf den zweiten Widerstandswert einzustellen, **dadurch gekennzeichnet, dass** die Messschaltung (101) konfiguriert ist, um zumindest ein Zeitfenster in Abhängigkeit von einer über die beiden bus-seitigen Anschlüsse (106, 108) empfangenen Nachricht und in Abhängigkeit von einer a-priori bekannten Position in Bezug zu der empfangenen Nachricht zu ermitteln, wobei die Widerstandsschaltung (104) konfiguriert ist, um den zwischen den zwei bus-seitigen Anschlüssen (106, 108) geschalteten Widerstand während des ermittelten Zeitfensters auf den zuletzt ermittelten zweiten Widerstandswert einzustellen, und wobei die Messschaltung (101) konfiguriert ist, um eine Wartezeitdauer nach einem Beginn des Zeitfensters abzuwarten, und um anschließend an die Wartezeitdauer und noch vor Ende des Zeitfensters den ersten Widerstandswert zwischen den beiden bus-seitigen Anschlüssen (106, 108) während einer Messzeitdauer zu messen.

2. Die Schaltung (100) nach dem Anspruch 1, wobei die Ermittlungsschaltung (102) konfiguriert ist, um den zweiten Widerstandswerts zu erhöhen, wenn der erste Widerstandswert sinkt.

3. Die Schaltung (100) nach dem Anspruch 1, wobei die Länge der Wartezeitdauer und/oder der Messzeitdauer eine Bit-Zeit oder kürzer ist.

4. Die Schaltung (100) nach einem der vorstehenden Ansprüche, wobei die Widerstandsschaltung (104) konfiguriert ist, um ein Zeitfenster zur Zuschaltung des Widerstandes zu ermitteln, und um den Widerstand während des Zeitfensters mit dem zuletzt ermittelten zweiten Widerstandswert zuzuschalten, und wobei die Messschaltung (101) konfiguriert ist, um den ersten Widerstand während des Zeitfensters zu ermitteln.

5. Die Schaltung (100) nach einem der vorstehenden Ansprüche, wobei die Ermittlungsschaltung (102) konfiguriert ist, um den zweiten Widerstandswert in Abhängigkeit von einem Vergleich des ersten Widerstandswerts mit einem Soll-Wert für den ersten Widerstandswert zu ermitteln.

6. Die Schaltung (100) nach einem der Ansprüche 1 bis 4, wobei die Ermittlungsschaltung (102) konfiguriert ist, um den zweiten Widerstandswerts mittels einer Lookup-Tabelle in Abhängigkeit von dem ersten Widerstandswert zu ermitteln.

7. Die Schaltung (100) nach dem Anspruch 6, wobei die Schaltung (100) umfasst:
- eine Konfigurationsschaltung (202), welche konfiguriert ist, um eine Anzahl (204) von Teilnehmerstationen des Bussystems bereitzustellen; und
- die Ermittlungsschaltung (102), welche konfiguriert ist, um den zweiten Widerstandswerts mittels der Lookup-Tabelle in Abhängigkeit von dem ersten Widerstandswert und in Abhängigkeit von der bereitgestellten Anzahl (204) von Teilnehmerstationen zu ermitteln.

8. Ein Transceiver für eine Teilnehmerstation eines Bussystems, wobei der Transceiver die Schaltung (100) nach einem der Ansprüche 1 bis 7 umfasst.

9. Ein Verfahren zum Betreiben einer Schaltung (100) für ein Bussystem, wobei das Verfahren umfasst:
- Messen (101) eines ersten Widerstandswerts zwischen zwei bus-seitigen Anschlüssen (106, 108) der Schaltung (100);
- Ermitteln (102) eines zweiten Widerstandswerts in Abhängigkeit von dem ersten Widerstandswert; und
- Einstellen (104) eines zwischen die zwei bus-seitigen Anschlüsse schaltbaren Widerstands auf den zweiten Widerstandswert, **dadurch gekennzeichnet, dass** zumindest ein Zeitfenster in Abhängigkeit von einer über die beiden bus-seitigen Anschlüsse (106, 108) empfangenen Nachricht und in Abhängigkeit von einer a-priori bekannten Position in Bezug zu der empfangenen Nachricht zu ermittel wird, wobei der zwischen den zwei bus-seitigen Anschlüssen (106, 108) geschaltete Widerstand während des ermittelten Zeitfensters auf den zuletzt ermittelten zweiten Widerstandswert eingestellt wird, und wobei eine Wartezeitdauer nach einem Beginn des Zeitfensters abgewartet wird, um anschließend an die Wartezeitdauer und noch vor Ende des Zeitfensters den ersten Widerstandswert zwischen den beiden bus-seitigen Anschlüssen (106, 108) während einer Messzeitdauer zu messen.

## Claims

1. Circuit (100) for a bus system, wherein the circuit (100) comprises:
- a measuring circuit (101) that is configured to measure a first resistance value between two bus-side connections (106, 108) of the circuit (100);
- an ascertainment circuit (102) that is configured to ascertain a second resistance value on the basis of the first resistance value; and
- a resistance circuit (104) that is configured to set a switchable resistor between the two bus-side connections (106, 108) to the second resistance value, **characterized in that** the measuring circuit (101) is configured to ascertain at least one time window depending on a message received via the two bus-side connections (106, 108) and depending on a position, which is known a priori, with respect to the received message, wherein the resistance circuit (104) is configured to set the resistor connected between the two bus-side connections (106, 108) to the last ascertained second resistance value during the ascertained time window, and wherein the measuring circuit (101) is configured to wait for a waiting period after the start of the time window, and to measure, following the waiting period and before the end of the time window, the first resistance value between the two bus-side connections (106, 108) during a measurement period.

2. Circuit (100) according to Claim 1, wherein the ascertainment circuit (102) is configured to increase the second resistance value if the first resistance value falls.

3. Circuit (100) according to Claim 1, wherein the length of the waiting period and/or the measurement period is a bit time or shorter.

4. Circuit (100) according to one of the preceding claims, wherein the resistance circuit (104) is configured to ascertain a time window for connecting in the resistor, and to connect in the resistor during the time window with the last ascertained second resistance value, and wherein the measuring circuit (101) is configured to ascertain the first resistor during the time window.

5. Circuit (100) according to one of the preceding claims, wherein the ascertainment circuit (102) is configured to ascertain the second resistance value on the basis of a comparison between the first resistance value and a target value for the first resistance value.

6. Circuit (100) according to one of Claims 1 to 4, wherein the ascertainment circuit (102) is configured to ascertain the second resistance value, by means of a lookup table, on the basis of the first resistance value.

7. Circuit (100) according to Claim 6, wherein the circuit (100) comprises:
- a configuration circuit (202) that is configured to provide a number (204) of subscriber stations of the bus system; and
- the ascertainment circuit (102) that is configured to ascertain the second resistance value, by means of the lookup table, on the basis of the first resistance value and on the basis of the provided number (204) of subscriber stations.

8. Transceiver for a subscriber station of a bus system, wherein the transceiver comprises the circuit (100) according to one of Claims 1 to 7.

9. Method for operating a circuit (100) for a bus system, wherein the method comprises:
- measuring (101) a first resistance value between two bus-side connections (106, 108) of the circuit (100);
- ascertaining (102) a second resistance value on the basis of the first resistance value; and
- setting (104) a switchable resistor between the two bus-side connections to the second resistance value, **characterized in that** at least one time window is ascertained depending on a message received via the two bus-side connections (106, 108) and depending on a position, which is known a priori, with respect to the received message, wherein the resistor connected between the two bus-side connections (106, 108) is set to the last ascertained second resistance value during the ascertained time window, and wherein a waiting period after the start of the time window is waited for, in order to measure, following the waiting period and before the end of the time window, the first resistance value between the two bus-side connections (106, 108) during a measurement period.

## Revendications

1. Circuit (100) pour un système de bus, le circuit (100) comprenant :
- un circuit de mesure (101) qui est configuré pour mesurer une première valeur de résistance entre deux bornes côté bus (106, 108) du circuit (100) ;
- un circuit de détermination (102) qui est configuré pour déterminer une deuxième valeur de résistance en fonction de la première valeur de résistance ; et
- un circuit de résistance (104) qui est configuré pour régler une résistance pouvant commuter entre les deux bornes côté bus (106, 108) sur la deuxième résistance, **caractérisé en ce que** le circuit de mesure (101) est configuré pour déterminer au moins une fenêtre temporelle en fonction d'un message reçu par l'intermédiaire des deux bornes côté bus (106, 108) et en fonction d'une position a priori connue par rapport au message reçu, dans lequel le circuit de résistance (104) est configuré pour régler la résistance connectée entre les deux bornes côté bus (106, 108) pendant la fenêtre temporelle déterminée sur la deuxième valeur de résistance déterminée en dernier, et dans lequel le circuit de mesure (101) est configuré pour attendre pendant une période d'attente après le début de la fenêtre temporelle et pour mesurer après la période d'attente et avant même la fin de la fenêtre temporelle la première valeur de résistance entre les deux bornes côté bus (106, 108) pendant une période de mesure.

2. Circuit (100) selon la revendication 1, dans lequel le circuit de détermination (102) est configuré pour augmenter la deuxième valeur de résistance si la première valeur de résistance baisse.

3. Circuit (100) selon la revendication 1, dans lequel la durée de la période d'attente et/ou de la période de mesure est un temps de bit ou moins.

4. Circuit (100) selon l'une quelconque des revendications précédentes, dans lequel le circuit de résistance (104) est configuré pour déterminer une fenêtre temporelle pour mettre en circuit la résistance et pour mettre en circuit la résistance pendant la fenêtre temporelle avec la deuxième valeur de résistance déterminée en dernier, et dans lequel le circuit de mesure (101) est configuré pour déterminer la première résistance pendant la fenêtre temporelle.

5. Circuit (100) selon l'une quelconque des revendications précédentes, dans lequel le circuit de détermination (102) est configuré pour déterminer la deuxième valeur de résistance en fonction d'une comparaison de la première valeur de résistance avec une valeur de consigne pour la première valeur de résistance.

6. Circuit (100) selon l'une quelconque des revendications 1 à 4, dans lequel le circuit de détermination (102) est configuré pour déterminer la deuxième valeur de résistance au moyen d'une table de consultation en fonction de la première valeur de résistance.

7. Circuit (100) selon la revendication 6, dans lequel le circuit (100) comprend :
- un circuit de configuration (202) qui est configuré pour fournir un nombre donné (204) de stations d'abonné du système de bus ; et
- le circuit de détermination (102) qui est configuré pour déterminer la deuxième valeur de résistance au moyen de la table de consultation en fonction de la première valeur de résistance et en fonction du nombre fourni (204) de stations d'abonné.

8. Emetteur-récepteur pour une station d'abonné d'un système de bus, l'émetteur-récepteur comprenant le circuit (100) selon l'une quelconque des revendications 1 à 7.

9. Procédé permettant de faire fonctionner un circuit (100) pour un système de bus, le procédé comprenant les étapes consistant à :
- mesurer (101) une première valeur de résistance entre deux bornes côté bus (106, 108) du circuit (100) ;
- déterminer (102) une deuxième valeur de résistance en fonction de la première valeur de résistance ; et
- régler (104) une résistance pouvant être commutée entre les deux bornes côté bus sur la deuxième valeur de résistance, **caractérisé en ce qu'**au moins une fenêtre temporelle est déterminée en fonction d'un message reçu par l'intermédiaire des deux bornes côté bus (106, 108) et en fonction d'une position a priori connue par rapport au message reçu, dans lequel la résistance connectée entre les deux bornes côté bus (106, 108) pendant la fenêtre temporelle déterminée est réglée sur la deuxième valeur de résistance déterminée en dernier, et dans lequel on attend pendant une période d'attente après le début de la fenêtre temporelle afin de mesurer après la période d'attente et avant même la fin de la fenêtre temporelle la première valeur de résistance entre les deux bornes côté bus (106, 108) pendant une période de mesure.
